# FASCICULE DE BREVET EUROPEEN

(11) **EP 2 979 526 B1**
(45) Date de publication et mention de la délivrance du brevet: **01.02.2017**
(21) Numéro de dépôt: 14718678.7
(22) Date de dépôt: 26.03.2014
(51) Int. Cl.: H05K 7/14, G01R 31/28

(54) **ENCEINTE D'ÉQUIPEMENT INDUSTRIEL**
GEHÄUSE EINER INDUSTRIELLEN VORRICHTUNG
ENCLOSURE OF AN INDUSTRIAL APPARATUS

(30) Priorité: 28.03.2013 FR 1352824
(43) Date de publication de la demande: 03.02.2016
(73) Titulaire: VIT, 38120 Saint-Egreve (FR)
(72) Inventeur: WOLF, Christian, F-38120 Saint-egreve (FR)
(74) Mandataire: Thibon, Laurent
(86) Numéro de dépôt international: PCT/FR2014/050710
(87) Numéro de publication internationale: WO 2014/155007

(56) Documents cités:
- US-A1- 2008 123 284
- US-A1- 2012 307 456

## Description

### Domaine

La présente description concerne de façon générale les installations industrielles et, plus particulièrement, les caissons, boîtiers, armoires ou enceintes d'équipements industriels. Un exemple d'application concerne les installations de traitement en ligne, par exemple de cartes électroniques, comportant une succession d'équipements d'inspection ou de traitement de ces cartes.

### Exposé de l'art antérieur

Les enceintes logeant des équipements industriels sont généralement formées d'un bâti et de parois pour enfermer l'équipement. Pour des besoins de maintenance, d'inspection ou de chargement, ces enceintes comportent généralement une porte d'accès permettant à un opérateur d'ouvrir l'enceinte.

Les portes d'accès sont entières ou partielles, c'est-à-dire qu'elles permettent ou non à l'opérateur d'entrer dans l'enceinte. Dans les applications que vise plus particulièrement la présente description, les portes d'accès à l'équipement sont partielles, l'opérateur restant à l'extérieur de l'enceinte pour les opérations de maintenance.

De plus en plus souvent, les équipements industriels sont équipés d'interfaces de commande exploitant un écran d'affichage ou de commande. L'opérateur a alors généralement besoin de consulter des informations, que ce soit lorsque l'enceinte est fermée ou lorsque la porte est ouverte. Cela oblige à prévoir un écran visible de l'extérieur, porte fermée, ainsi qu'un autre écran à l'intérieur de l'enceinte ou à l'intérieur de la porte. Cela est coûteux et peu commode.

Une autre solution d'un écran tournante est présentée dans les documents US2012307456 et US2008123284.

### Résumé

Un objet d'un mode de réalisation vise à proposer une porte d'accès à un espace interne d'une enceinte d'équipement industriel, équipée d'un écran, qui pallie tout ou partie des inconvénients des caissons usuels.

Un autre objet d'un mode de réalisation vise à faciliter l'accès d'un opérateur à un écran d'affichage ou de commande équipant la porte.

Pour atteindre tout ou partie de ces objets ainsi que d'autres, on prévoit une enceinte, comprenant une porte d'accès à un espace de réception d'équipement industriel, dans lequel la porte est articulée à un dormant porté par l'enceinte par au moins une bielle dont les extrémités sont articulées respectivement au dormant et en face arrière de la porte, approximativement au milieu de sa longueur.

Selon un mode de réalisation, une extrémité de la ou des bielles est articulée à un montant vertical du dormant.

Selon un mode de réalisation, une extrémité de la porte est montée à coulissement parallèlement au dormant.

Selon un mode de réalisation, le coulissement est horizontal.

Selon un mode de réalisation, une face de la porte, externe en position fermée, devient fonctionnellement interne en position ouverte.

Selon un mode de réalisation, une face externe de la porte en position fermée est, en position ouverte côté dormant.

Selon un mode de réalisation, ladite porte intègre un espace de réception d'un écran.

Selon un mode de réalisation, le dormant comporte, en partie haute ou basse, une gorge de réception d'un pivot fixé au voisinage d'un coin de la porte, distal de la ou des bielles.

Selon un mode de réalisation, le pivot définit un axe de rotation du coin de la porte, mobile en translation parallèlement au dormant.

Selon un mode de réalisation, l'enceinte comporte en outre des lumières de passage d'objets à traiter par l'équipement.

Selon un mode de réalisation, ladite porte est montée à l'aide d'au moins deux bras articulés d'une part au dormant et d'autre part en face arrière de la porte.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue de face schématique et partielle d'une enceinte d'équipement industriel, équipée d'un mode de réalisation d'une porte ;
la figure 2 représente l'enceinte de la figure 1, porte ouverte ;
les figures 3A, 3B et 3C sont des vues schématiques de dessus de la porte de l'enceinte des figures 1 et 2, respectivement en position fermée, dans une position intermédiaire et en position ouverte ;
la figure 4 est une vue schématique de l'arrière de la porte en position ouverte ; et
la figure 5 illustre un détail du mécanisme d'articulation de la porte.

### Description détaillée

De mêmes éléments ont été désignés par de mêmes références aux différentes figures. Par souci de clarté, seuls les éléments utiles à la compréhension des modes de réalisation décrits ont été représentés et seront détaillés. En particulier, seuls la porte et son mécanisme ont été illustrés, les modes qui vont être décrits étant compatibles avec les enceintes usuelles utilisées pour des équipements industriels. De plus, la nature des équipements contenus dans l'enceinte n'a pas été détaillée, les modes de réalisation décrits étant là encore compatibles avec les équipements usuels.

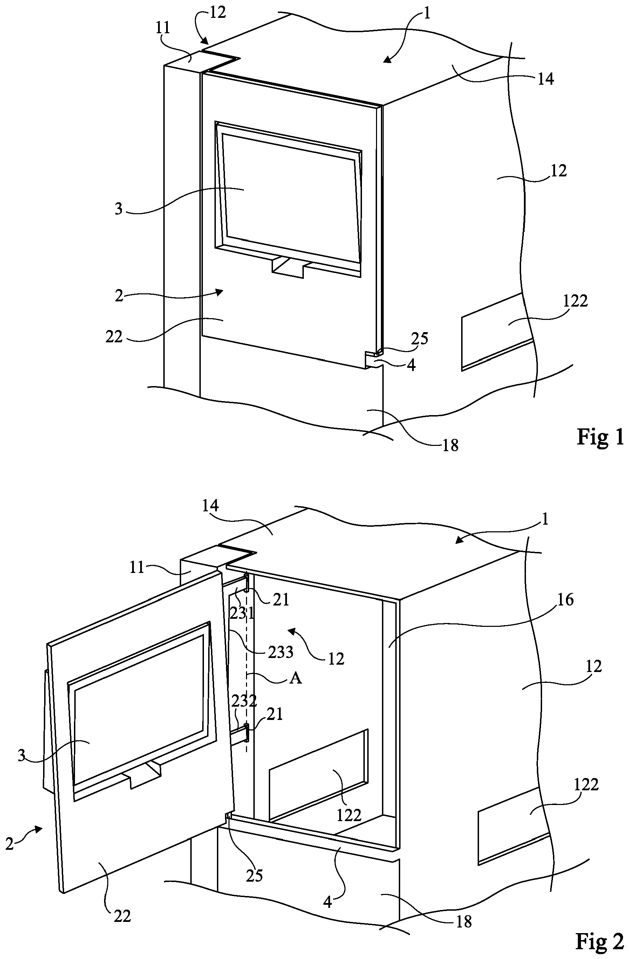

La figure 1 est une vue en perspective, de face, d'une enceinte 1, destinée à contenir un ou plusieurs équipements industriels (par exemple, une installation d'examen optique de cartes électroniques) et équipée d'une porte 2, illustrée fermée.

La figure 2 est une vue en perspective de l'enceinte de la figure 1, porte 2 ouverte.

L'enceinte 1 comporte différentes parois, par exemple en considérant un caisson parallélépipédique rectangle, des parois latérales 12, une paroi supérieure 14, le cas échéant un fond 16 (figure 2) et le plus souvent un socle (non visible aux figures). Selon l'installation ou l'équipement intégrant l'enceinte 1, les parois latérales 12 peuvent être omises si l'équipement est intégré dans une installation de traitement en ligne à la suite d'autres enceintes. En variante, les parois 12 comportent des lumières 122 ou ouvertures, destinées au transfert d'un poste à l'autre des objets (par exemple les cartes électroniques) à traiter, sans qu'il soit nécessaire d'ouvrir la porte pour recharger l'enceinte avec un nouveau lot. Par ailleurs, d'autres formes d'enceintes sont envisageables en fonction des équipements qu'elles sont destinées à loger.

En face avant 18, l'enceinte 1 comporte une porte 2 d'accès à l'espace intérieur. Cette porte 2 est articulée sur un dormant ou bâti de l'enceinte. Dans l'exemple décrit, on suppose la présence d'un montant vertical 11 d'un dormant faisant partie d'un bâti de l'enceinte auquel est articulée la porte 2.

La porte 2 comporte, en face externe 22, un écran 3 ou autre dispositif d'affichage. Dans l'exemple des figures 1 et 2, l'écran 3 est un écran plat, de préférence tactile pour servir à la fois de dispositif d'affichage et d'organe de commande. A titre de variante, la face externe 22 de la porte 2 comporte divers éléments d'affichage ou organes de commande, voire le cas échéant en étant dépourvue d'écran. Par exemple, il pourra s'agir d'une ou plusieurs séries d'indicateurs lumineux du fonctionnement de l'équipement et d'un ou plusieurs organes de commande destinés au fonctionnement ou à la maintenance de cet équipement.

L'articulation de la porte 2 à l'enceinte 1 est telle que l'écran 3 est visible par un opérateur lorsque la porte est fermée (figure 1) ainsi que lorsque la porte 2 est ouverte (figure 2) et que l'opérateur est en train d'intervenir à l'intérieur de l'enceinte. En d'autres termes, la face 22, externe de la porte en position fermée, devient fonctionnellement interne lorsque la porte est ouverte.

Cela permet, de façon particulièrement avantageuse, qu'un même écran 3 soit accessible facilement que l'enceinte soit ouverte ou fermée, et soit en particulier accessible alors que l'opérateur intervient au niveau de l'espace interne du caisson.

De préférence, l'extrémité droite de la porte (dans l'orientation des figures) est montée à coulissement en translation dans la gorge optionnelle 4. Par exemple, un pivot 25, saillant de l'extrémité inférieure de la partie droite de la porte 2, coulisse dans la gorge 4, cette dernière étant parallèle à la façade de l'enceinte. La présence de ce guidage à coulissement supprime un degré de liberté au mouvement de la porte et facilite sa manoeuvre en l'obligeant à suivre une cinématique donnée.

En d'autres termes, l'extrémité de la porte, opposée au montant vertical 11 lorsque la porte est fermée, est montée à coulissement horizontal parallèlement au dormant.

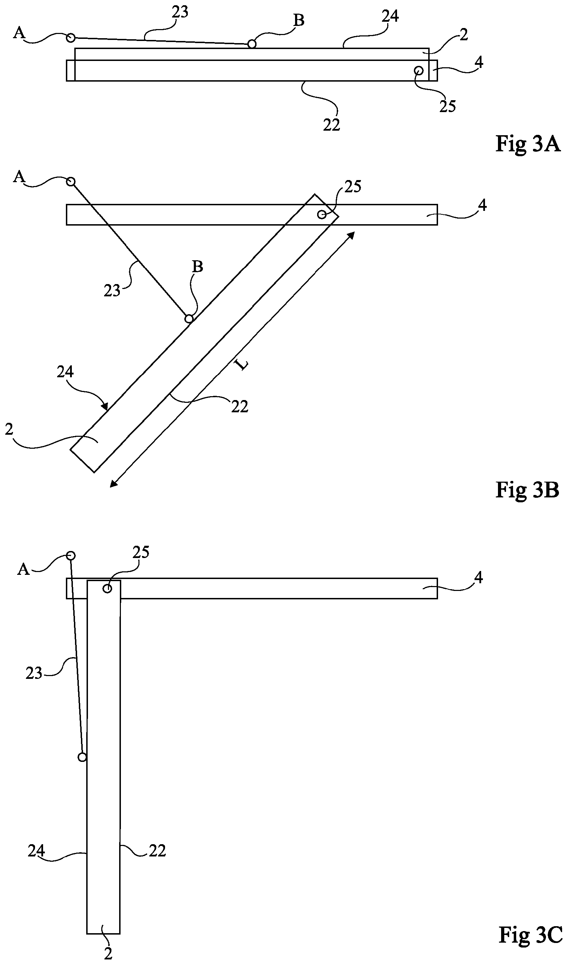

Les figures 3A, 3B et 3C sont des représentations très schématiques, vues de dessus, de la porte 2 respectivement en position fermée, dans une position intermédiaire et en position ouverte, illustrant la cinématique par rapport au dormant. Aux figures 3A à 3C, l'enceinte n'est pas détaillée mais apparaît sous la forme d'un axe d'articulation A, fixe par rapport au dormant, et de la gorge 4 de guidage de la porte en partie basse. L'axe A correspond à l'axe d'une ou plusieurs charnières 21 (figure 2) d'articulation de la porte 2 à l'enceinte 1.

La liaison du panneau de porte aux charnières 21 s'effectue par l'intermédiaire d'une ou plusieurs bielles 23, articulées par une de leurs extrémités à l'axe A (charnières 21) et par leurs autres extrémités respectives en face arrière 24 de la porte 2. La position de l'axe B d'articulation des bielles 23 à la porte 2, dans la longueur L de la porte, dépend entre autres de l'épaisseur de celle-ci. Idéalement, l'axe B est situé au milieu de la longueur L et, en pratique, approximativement au milieu soit à plus ou moins 10% de ce milieu par rapport à la longueur L. Le pivot 25 se trouve au coin ou approximativement au coin inférieur droit (distal des bielles) et définit un axe mu en translation dans la gorge 4 parallèlement au dormant de la porte.

La longueur des bielles 23 est au moins égale à la demi-longueur de la porte 2 de façon à autoriser son dégagement comme l'illustrent les figures 2 et 3C.

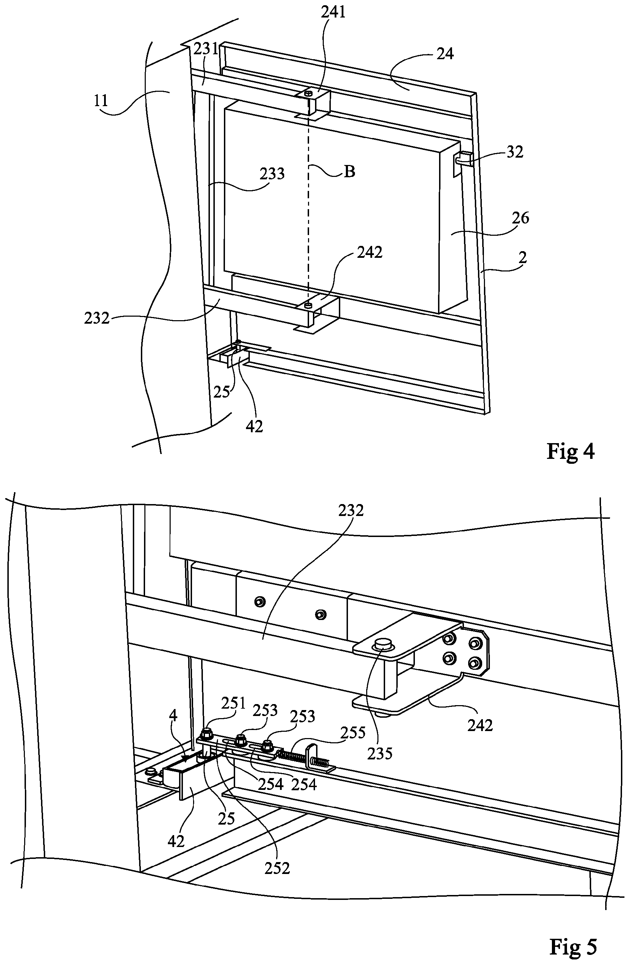

La figure 4 est une vue en perspective de la porte 2 en position ouverte vue de sa face arrière 24.

La figure 5 est un agrandissement de la partie basse de la porte illustrant le montage du pivot 25.

Dans le mode de réalisation préféré de la figure 4, le montage de la porte 2 sur le dormant 11 par l'intermédiaire du mécanisme à bielles 23 s'effectue à l'aide de deux bras horizontaux 231 et 232 respectivement haut et bas articulés par une première extrémité non visible en figure 4 aux charnières 21 (figure 2) et par leurs autres extrémités à des étriers 241 et 242 saillant de la face arrière 24 de la porte 2. L'articulation des bras (bielles) 231 et 232 aux étriers 241 et 242 ainsi qu'aux charnières 21 s'effectue, par exemple, par l'intermédiaire de gougeons 235 ou de tout autre moyen adapté. Pour des questions de rigidité, une barre approximativement verticale 233 relie les bras 231 et 232.

Le rôle des étriers 241 et 242 est, non seulement, d'articuler les bielles 231 et 232 mais également d'écarter leurs points d'articulation (axe B) de la face arrière 24. Un tel écart est optionnel mais permet de décaler les bras de l'épaisseur de l'écran logé dans la porte, surtout si la porte est bombée.

Dans l'exemple de la figure 4, l'écran est logé dans un carter 26 de protection. De préférence, l'écran 3 (non visible en figure 4) est inclinable en étant articulé à la face arrière 24 de la porte (articulation symbolisée en figure 4 par un pivot 32).

Selon un mode de réalisation préféré représenté en figure 5 (non illustré en figure 3C), le pivot 25 de guidage de la porte 2 dans la gorge 4 est relié à la porte avec un jeu autorisant le pivot 25 à sortir de l'alignement de la gorge 4 lorsque la porte arrive en fin de course en position ouverte (position illustrée par les figures 4 et 5). Pour cela, l'extrémité supérieure 251 du pivot 25 est fixée à une plaque 252 montée à coulissement par rapport à la porte 2. Ce coulissement est assuré, par exemple, par des lumières 254 dans lesquelles coulissent des pions ou tiges 253 fixés à la porte 2. En fin de course de la porte à l'ouverture, les lumières 253 permettent de décaler la porte par rapport à la gorge 4 vers l'extérieur de l'enceinte. Ce décalage de la porte lui permet de se retrouver dans une position perpendiculaire à la façade de l'enceinte comme illustré en figure 2, malgré son épaisseur et avec des bielles 231 de longueur fixe. En pratique, un ressort 255 assiste le mouvement de la plaque 252.

En variante, notamment si la porte n'est pas bombée, cette fonction est remplie par le déport des étriers 241 et 242.

En variante, si l'épaisseur de la porte le permet, on pourra prévoir des bielles 231 se retrouvant parallèles à la porte en position fermée. Toutefois, le montage à l'aide du pivot 25 constitue un mode de réalisation plus simple.

Les modes de réalisation et leurs variantes décrites ci-dessus facilitent considérablement l'utilisation de l'écran et le rendent accessible, quelle que soit la position ouverte ou fermée de la porte.

Un autre avantage induit par la cinématique proposée est que les câbles de connexion entre l'écran 3 et l'équipement auquel il doit être relié (en pratique un outil informatique) sont toujours masqués à l'opérateur.

Divers modes de réalisation ont été décrits, diverses variantes et modifications apparaîtront à l'homme de l'art. En particulier, bien que les modes de réalisation aient été décrits avec une porte ayant ses charnières à gauche, ces modes de réalisation se transposent à une porte ayant ses charnières à droite et à dégagement vers la droite. De plus, bien que la présence d'une gorge 4 en partie basse constitue un mode de réalisation préféré, car elle participe au soutien de la porte, cette gorge pourrait être en partie haute ou deux gorges peuvent être prévues. En outre, le nombre de bielles 23 dépend de la hauteur de la porte 2 et du besoin de tenue mécanique. Enfin, la mise en oeuvre pratique des modes de réalisation qui ont été décrits est à la portée de l'homme du métier à partir des indications fonctionnelles données ci-dessus, en tenant compte des dimensions de la porte et notamment de son épaisseur qui conditionne en particulier la position de l'axe B par rapport au milieu de la porte.

## Revendications

1. Enceinte (1), comprenant une porte (2) d'accès à un espace de réception d'équipement industriel, dans laquelle :
la porte est articulée à un dormant (11) porté par l'enceinte par au moins une bielle (23) dont les extrémités sont articulées respectivement à un montant vertical (11) du dormant et en face arrière (24) de la porte, approximativement au milieu de sa longueur ;
une extrémité de la porte est montée à coulissement horizontal parallèlement au dormant, une face de la porte, externe en position fermée, devenant fonctionnellement interne en position ouverte ; et
la porte intègre un espace (26) de réception d'un écran (3).

2. Enceinte selon la revendication 1, dans laquelle une face externe (22) de la porte (2) en position fermée est, en position ouverte, côté dormant (11).

3. Enceinte selon la revendication 1 ou 2, dans laquelle le dormant (11) comporte, en partie haute ou basse, une gorge (4) de réception d'un pivot (25) fixé au voisinage d'un coin de la porte, distal de la ou des bielles (23).

4. Enceinte selon la revendication 3, dans laquelle le pivot (25) définit un axe de rotation du coin de la porte (2), mobile en translation parallèlement au dormant (11).

5. Enceinte selon l'une quelconque des revendications 1 à 4, comportant en outre des lumières (122) de passage d'objets à traiter par l'équipement.

6. Enceinte selon l'une quelconque des revendications 1 à 3, dans laquelle ladite porte (2) est montée à l'aide d'au moins deux bras (231, 232) articulés d'une part au dormant (11) et d'autre part en face arrière (24) de la porte.

## Patentansprüche

1. Gehäuse (1), welches eine Tür (2) zum Zugriff auf einen Raum zur Aufnahme einer Industriemaschine aufweist,
wobei die Tür an einem Türrahmen (11), der von dem Gehäuse getragen wird, durch mindestens eine Verbindungsstange (23) aufgehängt ist, deren Enden jeweils schanierartig mit einem vertikalen Pfosten (11) des Türrahmens und mit der Hinterseite (24) der Tür ungefähr in der Mitte deren Länge verbunden ist; wobei ein Ende der Tür so montiert ist, dass es horizontal parallel zum Türrahmen gleitet, wobei eine Oberfläche der Tür, die in der geschlossenen Position außen ist, in der offenen Position funktionell innen wird; und
wobei in der Tür einen Raum (26) zum Aufnehmen einer Anzeige (3) integrieret ist.

2. Gehäuse nach Anspruch 1, wobei eine Oberfläche (22) der Tür (2), die in der geschlossenen Position außen ist, in der offenen Position auf der Seite des Türrahmens (11) ist.

3. Gehäuse nach einem der Ansprüche 1 oder 2, wobei der Türrahmen (11) in seinem oberen oder unteren Teil eine Nut (4) zur Aufnahme eines Zapfens (25) aufweist, der in der Nähe einer Ecke der Tür befestigt ist, und zwar entfernt von der (den) Verbindungsstange(n) (23).

4. Gehäuse nach Anspruch 3, wobei der Zapfen (25) eine Drehachse der Ecke der Tür (2) definiert, und zwar translatorisch parallel zum Türrahmen (11) bewegbar.

5. Gehäuse nach einem der Ansprüche 1- 4, das weiter Durchlässe (122) zum Durchlassen von Objekten aufweist, die von der Maschine bearbeitet werden sollen.

6. Gehäuse nach einem der Ansprüche 1- 3, wobei die Tür (2) durch mindestens zwei Arme (231, 232) befestigt ist, die schanierartig einerseits an dem Türrahmen (11) und andererseits an der Rückseite (24) der Tür befestigt sind.

## Claims

1. An enclosure (1) comprising a door (2) of access to a space for receiving an industrial apparatus, wherein:
the door is hinged on a door frame (11) supported by the enclosure by at least one connecting rod (23) having its ends respectively hingedly connected to a vertical post (11) of the door frame and to the rear surface (24) of the door, approximately in the middle of the length thereof;
one end of the door is assembled to horizontally slide parallel to the door frame, a surface of the door, external in closed position, becoming functionally internal in open position; and
the door integrates a space (26) for receiving a display (3).

2. The enclosure of claim 1, wherein a surface (22) of the door (2), external in closed position is, in open position, on the side of the door frame (11).

3. The enclosure of claim 1 or 2, wherein the door frame (11) comprises, in its upper or lower portion, a groove (4) for receiving a pin (25) fixed in the vicinity of one corner of the door, distal from the connecting rod(s) (23).

4. The enclosure of claim 3, wherein the pin (25) defines a rotation axis of the corner of the door (2), mobile in translation parallel to the door frame (11).

5. The enclosure of any of claims 1 to 4, further comprising ports (122) for the passage of objects to be processed by the apparatus.

6. The enclosure of any of claims 1 to 3, wherein said door (2) is assembled by means of at least two arms (231, 232) hinged on the one hand to the door frame (11) and on the other hand to the rear surface (24) of the door.
